# FASCICULE DE BREVET EUROPEEN

(11) **EP 1 374 242 B1**
(45) Date de publication et mention de la délivrance du brevet: **18.08.2004**
(21) Numéro de dépôt: 02730355.1
(22) Date de dépôt: 04.04.2002
(51) Int. Cl.: G11C 5/00, G11C 8/20, H03K 5/15

(54) **STOCKAGE D'UN CODE BINAIRE IMMUABLE DANS UN CIRCUIT INTEGRE**
SPEICHERN EINES UNVERÄNDERLICHEN BINÄRCODES IN EINER INTEGRIERTEN SCHALTUNG
STORING AN UNCHANGING BINARY CODE IN AN INTEGRATED CIRCUIT

(30) Priorité: 04.04.2001 FR 0104583
(43) Date de publication de la demande: 02.01.2004
(73) Titulaire: STMicroelectronics S.A., 92120 Montrouge (FR)
(72) Inventeur: BARDOUILLET, Michel, F-13790 Rousset (FR); WUIDART, Luc, F-83910 Pourrières (FR)
(74) Mandataire: de Beaumont, Michel
(86) Numéro de dépôt international: PCT/FR2002/001193
(87) Numéro de publication internationale: WO 2002/082449

(56) Documents cités:
- EP-A- 1 148 647
- DE-C- 19 510 038
- US-A- 3 911 368
- US-A- 4 023 110
- US-A- 4 675 612
- US-A- 5 204 559
- US-A- 5 686 850

## Description

La présente invention concerne le stockage, dans un circuit intégré, d'un code binaire immuable. L'invention s'applique plus particulièrement à l'inscription, lors de la fabrication du circuit, d'un code immuable destiné à être, lors de l'utilisation du circuit intégré, lu pour identifier le circuit, ou plus précisément une famille de circuits.

Un exemple d'application de la présente invention est l'authentification d'un élément ou ensemble électronique contenant un tel circuit intégré (par exemple, une carte à puce avec ou sans contacts), lors de transactions ou échanges d'informations avec un autre élément (par exemple, un terminal de lecture de cartes). Dans de telles applications, on doit s'assurer que le circuit intégré est authentique et n'est pas un circuit pirate ou un circuit émulé. En particulier dans le domaine des cartes à puces, il est actuellement difficile de lutter contre un piratage à grande échelle consistant à fabriquer des cartes pirates (clones) identiques aux cartes authentiques, c'est-à-dire intégrant les mêmes circuits et issues de filières technologiques semblables.

Parmi ces applications, l'invention concerne plus particulièrement celles où l'on souhaite inscrire un code immuable commun à plusieurs circuits. Il s'agit, par exemple, d'un identifiant du fabricant, d'un identifiant de la valeur d'origine d'une carte à unités de compte prépayées (cartes d'unités téléphoniques), etc.

Aujourd'hui, on a recours à des mémoires ou des registres enfouis dans le circuit intégré pour stocker ce ou ces codes. Le code est écrit de façon non modifiable dans l'élément de mémorisation lors ou après la fabrication.

Un inconvénient d'une telle technique est qu'elle requiert une programmation visible, rendant le code détectable hors du fonctionnement du circuit. En effet, que le code soit inscrit lors de la fabrication ou par programmation définitive ultérieure, les éléments de type fusibles ayant servis à cette inscription sont alors identifiables visuellement. Les progrès en matière d'analyse optique des circuits intégrés rendent alors possible le piratage du code.

Un autre inconvénient d'une telle technique est que l'authentification ultérieure du circuit, lors de son utilisation, requiert un processus de lecture de l'élément de mémorisation, ce qui prend du temps.

L'invention vise à proposer une nouvelle solution pour stocker un code binaire dans un circuit intégré.

L'invention vise, plus particulièrement, à permettre le stockage d'un code qui ne soit pas détectable visuellement, même avec des moyens de détection optiques performants.

L'invention vise également à proposer une solution qui fournisse le code stocké sans passer par une procédure de type lecture d'une mémoire, et de façon quasi instantanée.

L'invention vise également à proposer une solution ne nécessitant pas de programmation du circuit après fabrication.

L'invention vise en outre à proposer une solution particulièrement simple à mettre en oeuvre.

Pour atteindre ces objets, la présente invention prévoit un circuit de stockage d'un code binaire dans une puce de circuit intégré, comportant :
une borne d'entrée d'application d'un signal (E) de déclenchement d'une lecture du code ;
des bornes de sortie propres à délivrer ledit code binaire ;
des premiers chemins électriques reliant individuellement ladite borne d'entrée à chaque borne de sortie, chaque chemin apportant un retard fixé à la fabrication du circuit intégré ; et
des moyens de prise en compte simultanée des états binaires présents en sortie des chemins électriques.

Selon un mode de réalisation de la présente invention, chaque premier chemin électrique est constitué d'un élément retardateur et d'une bascule dont une borne d'entrée est reliée en sortie de l'élément retardateur correspondant et dont une borne de sortie définit une des bornes de sortie du circuit.

Selon un mode de réalisation de la présente invention, lesdits moyens de prise en compte comprennent un deuxième chemin électrique apportant un retard compris dans la plage des retards apportés par lesdits premiers chemins, ledit deuxième chemin étant intercalé entre ladite borne d'entrée et une borne de déclenchement de prise en compte desdits états binaires.

Selon un mode de réalisation de la présente invention, les entrées d'horloge des différentes bascules sont toutes reliées à ladite borne de déclenchement.

Selon un mode de réalisation de la présente invention, les premiers chemins électriques sont choisis pour apporter des retards qui restent inférieurs ou supérieurs au retard du deuxième chemin, malgré d'éventuelles dispersions technologiques.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un mode de réalisation d'un circuit de stockage intégré selon la présente invention ; et
les figures 2A et 2B illustrent, sous forme de chronogrammes, le fonctionnement du circuit de la figure 1, pour deux codes différents.

Par souci de clarté, seuls les éléments qui sont nécessaires à la compréhension de l'invention ont été représentés aux figures et seront décrits par la suite. En particulier, la destination et l'exploitation faite du code binaire stocké n'ont pas été détaillées et ne font pas l'objet de l'invention.

Une caractéristique de la présente invention est de stocker un code binaire au moyen de paramètres physiques du circuit intégré lui-même. Plus précisément, l'invention prévoit de faire subir, à un même signal d'entrée (signal logique comprenant au moins un front), plusieurs retards différents provenant de chemins électriques distincts.

Une autre caractéristique de l'invention est de prévoir une comparaison directe des retards apportés par les différents chemins par rapport à un retard intermédiaire, afin de rendre les retards du code insensibles aux dispersions technologiques et/ou de procédé de fabrication.

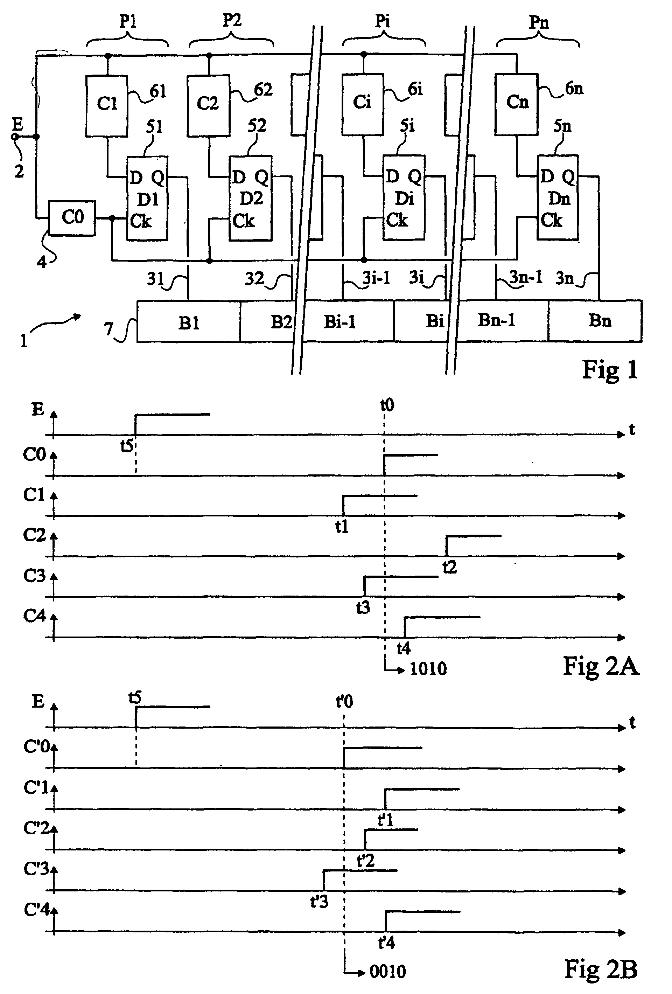

La figure 1 représente le schéma électrique d'un mode de réalisation d'un circuit de stockage intégré selon la présente invention.

Dans cet exemple, le circuit 1 comporte une unique borne 2 d'entrée destinée à recevoir un signal numérique E de déclenchement d'une lecture du code. Selon l'invention, le signal E à lui seul suffit pour que le code soit fourni. Pour la mise en oeuvre de l'invention, le signal E doit comprendre, comme on le verra par la suite en relation avec les figures 2A et 2B, au moins un front par lecture déclenchée.

Le circuit 1 délivre un code binaire B₁, B₂, ..., Bᵢ₋₁, Bᵢ, ..., Bₙ₋₁, Bₙ sur un nombre de bits prédéterminé. Chaque bit Bi est délivré sur une borne 3₁, 3₂, ..., 3ᵢ₋₁, 3ᵢ, ..., 3ₙ₋₁, 3ₙ du circuit 1 qui lui est propre. Le circuit 1 délivre donc le code binaire sous forme parallèle.

Selon l'invention, à chaque bit Bi du code est associé un chemin électrique P₁, P₂, ..., Pᵢ, ..., Pₙ reliant la borne d'entrée commune 2 à une borne 3ᵢ de même rang.

On voit donc déjà que, par les différents retards apportés par les chemins électriques, le front déclencheur du signal d'entrée E est reproduit sur les différentes sorties à des instants différents.

Selon l'invention, on prévoit d'effectuer la lecture de l'information présente aux sorties du circuit 1 de façon synchronisée. De préférence, on choisit un instant correspondant, de façon approximative, à un instant intermédiaire entre les retards extrêmes apportés par les différents chemins électriques.

Plus précisément, selon le mode de réalisation préféré de l'invention illustré par la figure 1, on prévoit un chemin électrique 4 (C0) pour fixer l'instant de lecture à partir de l'apparition du front déclencheur du signal d'entrée E. Ce chemin électrique de déclenchement est choisi pour apporter un retard compris dans la plage des retards dus aux chemins fournissant le code. Il s'agira, par exemple du retard moyen.

Par exemple, le chemin 4 relie l'entrée 2 du circuit 1 aux bornes Ck de bascules 5₁, 5₂, ..., 5ᵢ, ..., 5ₙ faisant partie des chemins électriques respectifs P₁, P₂, ..., Pᵢ, ..., Pₙ et dont les sorties respectives Q constituent les bornes 3₁, 3₂, ..., 3ᵢ, ..., 3ₙ de sortie du circuit 1. Selon ce mode de réalisation, chaque chemin électrique Pi comporte un élément retardateur 6₁ (C1), 6₂ (C2) ..., 6ᵢ (Ci) ..., 6ₙ (Cn) reliant l'entrée 2 du circuit à l'entrée D de la bascule correspondante du chemin. Les éléments retardateurs 6ᵢ sont les éléments qui présentent, selon la présente invention, des retards différents les uns par rapport aux autres. En effet, les bascules 5ᵢ ont, de préférence, la même constitution. Elles participent toutefois au retard apporté au signal d'entrée jusqu'aux bornes de sortie respectives du circuit 1 par rapport au retard C0 apporté par l'élément 4.

Lorsqu'on applique un front sur le signal d'entrée E, ce front arrive sur les entrées D respectives des bascules à des instants différents. La lecture de l'état d'entrée des différentes bascules est synchronisée par le front du signal E retardé, cette fois, par l'élément 4. C'est notamment pour cette raison que l'on choisit préférentiellement un retard C0 correspondant approximativement au retard moyen des différents éléments 6ᵢ.

Dans l'exemple de la figure 1, les différentes sorties 3ᵢ du circuit 1 sont reliées individuellement en entrée d'un registre 7 de mémorisation du code binaire obtenu, chaque bit Bi correspondant à l'une des sorties du circuit. Les détails de connexion et de constitution du registre 7 n'ont pas été représentés et ne font pas l'objet de la présente invention. Une fois le code binaire contenu dans ce registre, son exploitation dépend de l'application, et sa mise en oeuvre est à la portée de l'homme du métier.

Les figures 2A et 2B illustrent, sous forme de chronogrammes et sans respect d'échelle, le fonctionnement d'un circuit de stockage selon l'invention. Les figures 2A et 2B représentent des exemples d'allures du signal E, et des signaux en sortie des différents éléments retardateurs. Dans l'exemple des figures 2A et 2B, on considère le cas d'un code binaire sur quatre bits. Les chronogrammes ont été désignés par les références C0, C1, C2, C3 et C4, respectivement C'0, C'1, C'2, C'3 et C'4 pour illustrer que les éléments retardateurs y sont différents.

La différence entre les figures 2A et 2B représente la différence entre deux circuits 1 intégrés ayant des chemins C0 à C4 apportant des retards différents.

En figure 2A, on suppose qu'à un instant t5, on déclenche un front montant sur le signal E. Ce front apparaît sur les différentes entrées des bascules D (correspondant aux sorties des éléments retardateurs C1, C2, C3 et C4) à des instants respectifs différents t1, t2, t3 et t4. Par ailleurs, l'élément 4 (C0) apporte un retard déclenchant la lecture des données en entrée des bascules à un instant t0. Tous les chemins qui génèrent un retard supérieur au retard C0 fournissent un bit à l'état 0 dans la mesure où le front du signal E ne leur est pas encore parvenu. Tous les chemins qui génèrent un délai inférieur au délai C0 produisent un bit à l'état 1 dans la mesure où le front du signal E arrive sur l'entrée de la bascule correspondante avant l'expiration du délai C0. Dans l'exemple de la figure 2A, à l'instant t0, on fournit le code 1010.

La figure 2B illustre un circuit similaire dans lequel les chemins C0' à C4' sont différents. Le code obtenu y est différent. Par exemple, il s'agit du code 0010. En figure 2B, on a fait apparaître arbitrairement un instant t5 identique au cas de la figure 1. Par contre, les instants t'0, t'1, t'2, t'3 et t'4 auxquels le front du signal E a terminé de parcourir les chemins respectifs C'0, C'1, C'2, C'3 et C'4 sont différents du cas de la figure 2A.

De préférence, les retards apportés par les différents chemins sont choisis suffisamment différents les uns des autres pour être insensibles aux dispersions technologiques et de procédé de fabrication. On garantit ainsi que tous les circuits d'une même famille fournissent bien un même code. De préférence, dans le cas de plus de deux chemins, ceux-ci sont différents les uns des autres même s'ils doivent fournir le même résultat (0 ou 1). Cela rend encore moins exploitable une distinction visuelle entre les chemins.

Pour conférer un code différent d'un circuit à un autre, on peut modifier les chemins électriques pour qu'ils apportent des retards différents, ou modifier l'affectation des différents chemins aux différentes bascules, ce qui modifie l'ordre des bits dans le code. On pourra encore jouer sur le retard moyen C0 pour décaler l'instant de déclenchement des bascules. Dans ce cas, on veillera à ce que tous les chemins apportent des retards qui soient, les uns par rapport aux autres, indépendants des dispersions technologiques.

Selon un mode de mise en oeuvre de l'invention, le code à stocker est prédéterminé avant la fabrication du circuit. Dans ce cas, on dimensionne les éléments retardateurs C1 à Cn et/ou l'élément C0 pour que le circuit délivre ce code.

Selon un autre mode de mise en oeuvre, le code est inconnu lors de la conception du circuit. Il est alors identifié après fabrication par un déclenchement de lecture du code d'un des circuits de la famille. Ce code est commun à tous les circuits de la famille (fabriqués avec les mêmes masques). Il peut donc être par la suite exploité, par exemple, comme code d'identification du type de circuit.

On peut également envisager d'individualiser les codes de chaque puce d'une même plaquette que ce soit en individualisant les masques ou équivalents, ou en prévoyant des retards sensibles aux dispersions technologiques.

Un avantage de la présente invention est que le code stocké est indécelable visuellement. En effet, pour que le code apparaisse, il est nécessaire d'appliquer un signal électrique en entrée du circuit de l'invention.

Un autre avantage de la présente invention est qu'elle ne nécessite pas l'organisation d'un processus de lecture pour extraire le code, comme c'est le cas dans une mémoire classique. Selon l'invention il suffit d'appliquer un front sur le signal E pour voir apparaître, avec un délai qui dépend du retard moyen, le code sur les bornes de sortie. On économise ainsi du temps de cycle du système exploitant le circuit intégré.

Un autre avantage de la présente invention est que l'identification est particulièrement précise et fiable. En particulier, en supprimant le recours à une mesure (lecture d'une mémoire), on s'affranchit d'éventuels problèmes de précision.

Un autre avantage de l'invention est que la fourniture du code est très rapide. En effet, les dispersions des procédés de fabrication ou technologiques apportent le plus souvent des différences de l'ordre d'au plus une centaine de picosecondes. Par conséquent, des chemins apportant des retards dans une plage de quelques centaines de picosecondes suffisent pour délivrer un code. Le temps de fourniture du code peut alors être de l'ordre de la nanoseconde.

Un autre avantage de la présente invention est qu'en cas de dérive dans le temps d'un des retards apportés par les éléments, cela n'affecte pas les résultats du circuit. En effet, tous les éléments de retard étant de préférence de constitution similaire, la dispersion sera dans le même sens pour tous les éléments (chemins).

Pour réaliser les éléments retardateurs des chemins électriques de l'invention, on pourra utiliser n'importe quels éléments intégrés. Il pourra s'agir, par exemple, de séries de résistances et/ou de condensateurs ou de simples pistes. Pour les résistances, on pourra recourir à des résistances dans l'épaisseur du circuit intégré, mais on préférera utiliser des résistances en silicium polycristallin dont la valeur est liée à la géométrie et qui présentent l'avantage d'être moins dépendante de la température.

Selon l'invention, une phase de lecture est déclenchée par un front du signal d'entrée E. Le nombre de phases dépend de l'application et de la destination du circuit d'identification. S'il s'agit d'une carte à puce, on pourra prévoir, par exemple, une identification à chaque échange effectué entre cette carte et un dispositif externe, même au cours de la même transaction.

Bien entendu, la présente invention est susceptible de diverses variantes et modifications qui apparaîtront à l'homme de l'art. En particulier, la réalisation pratique des éléments retardateurs de l'invention pourra prendre des formes différentes.

De plus, le choix de la plage de variation des retards apportés par les différents éléments dépendent de l'application et de la sensibilité souhaitée. Ce choix est à la portée de l'homme du métier à partir des indications fonctionnelles données ci-dessus.

Par ailleurs, on notera que le nombre de bits du code fourni par le circuit de l'invention dépend également de l'application et du degré d'inviolabilité souhaité. Plus le nombre de bits est élevé plus on rend difficile la distinction entre deux circuits stockant des codes différents.

En outre, on pourra prévoir différents éléments d'exploitation du code binaire lors de l'utilisation du circuit. Au lieu d'être stocké dans un registre, celui-ci pourra, par exemple, être exploité directement pour valider ou invalider une fonction du circuit dans lequel il est intégré, par exemple, l'alimentation de ce circuit.

Enfin, bien qu'un mode de réalisation préféré ait recours à un unique signal E de déclenchement d'une lecture, on pourra prévoir, notamment dans le cas d'un circuit intégrant plusieurs codes, plusieurs signaux de déclenchement. Dans un tel cas, les différents codes pourront ou non partager un même retard C0.

Parmi les applications de la présente invention, on peut envisager d'utiliser le code comme identifiant du type de circuit pour un placement automatisé des puces par un robot qui les identifie au préalable par leur code.

## Revendications

1. Circuit (1) de stockage d'un code binaire dans une puce de circuit intégré, **caractérisé en ce qu'**il comporte :
une unique borne (2) d'entrée d'application d'un signal (E) de déclenchement d'une lecture du code ;
des bornes (3₁, 3₂, ..., 3ᵢ₋₁, 3ᵢ, ..., 3ₙ₋₁, 3ₙ) de sortie propres à délivrer ledit code binaire ;
des premiers chemins électriques (P₁, P₂, ..., Pᵢ, ..., Pₙ) reliant individuellement ladite borne d'entrée à chaque borne de sortie, chaque chemin apportant un retard fixé à la fabrication du circuit intégré ; et
des moyens (4, 5₁, 5₂, ..., 5ᵢ, ..., 5ₙ) de prise en compte simultanée des états binaires présents en sortie des chemins électriques, déclenchés par ledit signal.

2. Circuit selon la revendication 1, **caractérisé en ce que** chaque premier chemin électrique est constitué d'un élément retardateur (6₁, 6₂, ..., 6ᵢ, ..., 6ₙ) et d'une bascule (5₁, 5₂, ..., 5ᵢ, ..., 5ₙ) dont une borne d'entrée (D) est reliée en sortie de l'élément retardateur correspondant et dont une borne de sortie (Q) définit une des bornes de sortie du circuit.

3. Circuit selon la revendication 1 ou 2, **caractérisé en ce que** lesdits moyens de prise en compte comprennent un deuxième chemin électrique (4) apportant un retard (C0) compris dans la plage des retards apportés par lesdits premiers chemins, ledit deuxième chemin étant intercalé entre ladite borne d'entrée (2) et une borne de déclenchement de prise en compte desdits états binaires.

4. Circuit selon les revendications 2 et 3, **caractérisé en ce que** les entrées d'horloge (Ck) des différentes bascules sont toutes reliées à ladite borne de déclenchement.

5. Circuit selon la revendication 3 ou 4, **caractérisé en ce que** les premiers chemins électriques sont choisis pour apporter des retards qui restent inférieurs ou supérieurs au retard du deuxième chemin (C0), malgré d'éventuelles dispersions technologiques.

## Patentansprüche

1. Eine Schaltung (1) zum Speichern eines Binärcodes in einem integrierten Schaltungschip, **gekennzeichnet durch**:
einen Eingangsanschluss (2) zum Anlegen eines Signals (E) zum Auslösen eines Lesevorgangs des Codes;
Ausgangsanschlüsse (3₁, 3₂, ..., 3ᵢ₋₁, 3ᵢ, ..., 3ₙ₋₁, 3ₙ), geeignet zum Vorsehen des erwähnten Binärcodes;
erste elektrische Pfade (P₁, P₂, ..., Pᵢ, ..., Pₙ), die individuell den erwähnten Eingangsanschluss mit jedem Ausgangsanschluss verbinden, wobei jeder Pfad eine beim Herstellen der integrierten Schaltung eingestellte Verzögerung einführt; und
Mittel (4, 5₁, 5₂, ..., 5ᵢ, ..., 5ₙ) zum gleichzeitigen Berücksichtigen der an den Ausgängen der elektrischen Pfade vorhandenen Binärzustände.

2. Schaltung nach Anspruch 1, **dadurch gekennzeichnet, dass** jeder erste elektrische Pfad ein Verzögerungselement (6₁, 6₂, ..., 6ᵢ, ..., 6ₙ) und ein Flip-Flop (5₁, 5₂, ..., 5ᵢ, ..., 5ₙ) aufweist, und zwar mit einem Eingangsanschluss (D), verbunden mit dem Ausgang des entsprechenden Verzögerungselements und mit einem Ausgangsanschluss (Q), der eine der Ausgangsanschlüsse der Schaltung definiert.

3. Schaltung nach Anspruch 1 oder 2, **dadurch gekennzeichnet, dass** die erwähnten Mittel zur Berücksichtigung einen zweiten elektrischen Pfad (4) aufweisen, der eine Verzögerung (C0) umschlossen im Bereich der Verzögerungen, eingeführt durch die erwähnten ersten Pfade, einführt, wobei der erwähnte zweite Pfad zwischen dem Eingangsanschluss (2) und einem Anschluss zum Auslösen oder Triggern der Berücksichtigung der erwähnten Binärzustände angeordnet ist.

4. Schaltung nach den Ansprüchen 2 und 3, **dadurch gekennzeichnet, dass** jeder der Takt- oder Clockeingänge (Ck) der unterschiedlichen Flip-Flops mit dem erwähnten Auslöse- oder Triggeranschluss verbunden ist.

5. Schaltung nach Anspruch 3 oder 4, **dadurch gekennzeichnet, dass** die ersten elektrischen Pfade zur Einführung von Verzögerungen ausgewählt sind, die kürzer oder länger bleiben als die Verzögerung des zweiten Pfades (C0) trotz möglicher technologischer Dispersionen.

## Claims

1. A circuit (1) for storing a binary code in an integrated circuit chip, **characterized in that** it includes:
an input terminal (2) of application of a signal (E) for triggering a reading of the code;
output terminals (3₁, 3₂, ..., 3ᵢ₋₁, 3ᵢ, ..., 3ₙ₋₁, 3ₙ) adapted to providing said binary code;
first electric paths (P₁, P₂, ..., Pᵢ, ..., Pₙ) individually connecting said input terminal to each output terminal, each path introducing a delay set upon manufacturing of the integrated circuit; and
means (4, 5₁, 5₂, ..., 5ᵢ, ..., 5ₙ) for simultaneously taking into account binary states present at the outputs of the electric paths.

2. The circuit of claim 1, **characterized in that** each first electric path comprises a delay element (6₁, 6₂, ..., 6ᵢ, ..., 6ₙ) and of a flip-flop (5₁, 5₂, ..., 5ᵢ, ..., 5ₙ) having an input terminal (D) connected at the output of the corresponding delay element and having an output terminal (Q) defining one of the output terminals of the circuit.

3. The circuit of claim 1 or 2, **characterized in that** said means for taking into account include a second electric path (4) introducing a delay (C0) included in the range of the delays introduced by said first paths, said second path being interposed between said input terminal (2) and a terminal for triggering the taking into account of said binary states.

4. The circuit of claims 2 and 3, **characterized in that** each clock inputs (Ck) of the different flip-flops is connected to said triggering terminal.

5. The circuit of claim 3 or 4, **characterized in that** the first electric paths are chosen to introduce delays which remain shorter or longer than the delay of the second path (C0), despite possible technological dispersions.
